# EUROPEAN PATENT APPLICATION

(11) **EP 4 647 783 A1**
(43) Date of publication of application: **12.11.2025**
(21) Application number: 23924338.9
(22) Date of filing: 17.11.2023
(51) Int. Cl.: G01R 31/36, G01R 31/396, G01R 31/392, G01R 31/382, G01R 31/385, G01R 19/10

(54) **BATTERY DIAGNOSTIC DEVICE AND OPERATION METHOD THEREOF**

(30) Priority: 21.02.2023 KR 20230023232; 08.06.2023 KR 20230073410
(71) Applicant: LG Energy Solution, Ltd., Seoul 07335 (KR)
(72) Inventor: KIM, Young Min, Daejeon 34122 (KR); PARK, Jung Uk, Daejeon 34122 (KR); IN, Jeong Hyeon, Daejeon 34122 (KR)
(74) Representative: Plasseraud IP
(86) International application number: PCT/KR2023/018593
(87) International publication number: WO 2024/177232

(57) **Abstract**

A battery diagnosis apparatus according to an embodiment disclosed herein includes an obtaining unit configured to obtain open circuit voltage (OCV) data of a battery unit, a calculating unit configured to calculate an OCV deviation indicating a difference between an average OCV of a plurality of battery units included in a higher-level battery unit and OCVs of the plurality of battery units, based on the OCV data, and calculate a plurality of OCV deviation change values of the plurality of battery units in at least one time window, a setting unit configured to set a threshold deviation corresponding to the higher-level battery unit, and a diagnosing unit configured to diagnose abnormality of the higher-level battery unit based on the plurality of OCV deviation change values of the plurality of battery units and the threshold deviation.

## Description

### [TECHNICAL FIELD]

### CROSS-REFERENCE TO RELATED APPLICATION

This application claims priority to and the benefit of Korean Patent Application No. 10-2023-0023232 filed in the Korean Intellectual Property Office on February 21, 2023, and Korean Patent Application No. 10-2023-0073410 filed in the Korean Intellectual Property Office on June 8, 2023, the entire contents of which are incorporated herein by reference.

### TECHNICAL FIELD

Embodiments disclosed herein relate to a battery diagnosis apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery may be used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (EV, HEV, PHEV) driven with electricity, large-volume energy storage systems (ESS), etc.

These batteries may be managed and controlled in terms of states and operations thereof by a battery management system (BMS). The battery management system may be included together with a battery in one device.

The battery management system may also manage and control the battery in a state of being spaced apart from a device including the battery. For example, the battery management system may be implemented as a separate server device. In this case, the battery management system may collect battery data and vehicle data from the vehicle, etc., and manage and control the battery using the collected data.

### [DISCLOSURE]

### [TECHNICAL PROBLEM]

When a short circuit or a failure of another type occurs inside a battery, the possibility of damage to devices (e.g., EV, ESS) including the battery may increase. Accordingly, there is a need for a scheme to reduce the possibility of damage to devices including a battery by detecting an abnormal state of the battery.

Conventionally, a battery cell has been diagnosed by a calculation scheme using all of a state of charge (SOC), current, capacity, and open circuit voltage (OCV) information. According to such a diagnosis method, because of use of many factors, it may be difficult to perform diagnosis when specific information out of the foregoing information is missing. This may be a big issue in the battery management system implemented with a server device that has to collect data from the vehicle, and may excessively increase memory usage. Thus, there is a need for data simplification required for battery diagnosis.

According to embodiments disclosed herein, there may be provided a battery diagnosis apparatus and an operating method thereof by which abnormality of a battery may be diagnosed merely using battery OCV data information.

Technical problems of the embodiments disclosed herein are not limited to the above-described technical problems, and other unmentioned technical problems would be clearly understood by one of ordinary skill in the art from the following description.

### [TECHNICAL SOLUTION]

A battery diagnosis apparatus according to an embodiment disclosed herein includes an obtaining unit configured to obtain open circuit voltage (OCV) data of a battery unit, a calculating unit configured to calculate an OCV deviation indicating a difference between an average OCV of a plurality of battery units included in a higher-level battery unit and OCVs of the plurality of battery units, based on the OCV data, and calculate a plurality of OCV deviation change values of the plurality of battery units in at least one time window, and a diagnosing unit configured to set a threshold deviation corresponding to the higher-level battery unit and diagnose abnormality of the higher-level battery unit based on the plurality of OCV deviation change values of the plurality of battery units and the threshold deviation.

The battery diagnosis apparatus according to an embodiment disclosed herein may further include a limiting unit configured to limit a time length of the at least one time window to a designated range, in which a setting unit may be configured to set the threshold deviation based on the designated range.

In the battery diagnosis apparatus according to an embodiment disclosed herein, the calculating unit may be further configured to limit a time length of the at least one time window to a designated range, and the diagnosing unit may be further configured to set the threshold deviation based on the designated range.

In the battery diagnosis apparatus according to an embodiment disclosed herein, the diagnosing unit may be further configured to set the threshold deviation to a first threshold deviation when the designated range is less than or equal to a first time length and set the threshold deviation to a second threshold deviation that is greater than the first threshold deviation, when the designated range is at least the second time length but not more than the third time length that is greater than the second time length.

The battery diagnosis apparatus according to an embodiment disclosed herein may further include an identifying unit configured to identify presence of a low-voltage period in the plurality of battery units, based on the OCV deviation of the plurality of battery units, in which the diagnosing unit is further configured to set the threshold deviation based on the presence of the low-voltage period.

In the battery diagnosis apparatus according to an embodiment disclosed herein, the identifying unit may be further configured to identify that the low-voltage period is present, when there is a battery unit having an OCV deviation greater than or equal to a designated value among the plurality of battery units.

In the battery diagnosis apparatus according to an embodiment disclosed herein, the diagnosing unit may be further configured to set the threshold deviation to a third threshold deviation when it is identified that the low-voltage period is present, and set the threshold deviation to a fourth threshold deviation that is greater than the third threshold deviation when it is identified that the low-voltage period is not present.

In the battery diagnosis apparatus according to an embodiment disclosed herein, the diagnosing unit may be further configured to compare a maximum value among the plurality of OCV deviation change values of the plurality of battery units with the threshold deviation to diagnose abnormality of the higher-level battery unit.

In the battery diagnosis apparatus according to an embodiment disclosed herein, the diagnosing unit may be further configured to diagnose that the higher-level battery unit is abnormal when the maximum value is greater than or equal to the threshold deviation.

In the battery diagnosis apparatus according to an embodiment, the calculating unit may be further configured to extract OCV data in a designated voltage range from the OCV data and calculate the OCV deviation of the plurality of battery units, based on the extracted OCV data in the designated voltage range.

A battery diagnosis method according to an embodiment disclosed herein includes obtaining open circuit voltage (OCV) data of a battery unit, calculating an OCV deviation indicating a difference between an average OCV of a plurality of battery units included in a higher-level battery unit and OCVs of the plurality of battery units, based on the OCV data, calculating a plurality of OCV deviation change values of the plurality of battery units in at least one time window, setting a threshold deviation corresponding to the higher-level battery unit, and diagnosing abnormality of the higher-level battery unit based on the plurality of OCV deviation change values of the plurality of battery units and the threshold deviation.

The battery diagnosis method according to an embodiment disclosed herein may further include limiting a time length of the at least one time window to a designated range, in which the setting of the threshold deviation includes setting the threshold deviation based on the designated range.

In the battery diagnosis method according to an embodiment disclosed herein, the setting of the threshold deviation may include setting the threshold deviation to a first threshold deviation when the designated range is less than or equal to a first time length and setting the threshold deviation to a second threshold deviation that is greater than the first threshold deviation, when the designated range is at least the second time length but not more than the third time length that is greater than the second time length.

The battery diagnosis method according to an embodiment disclosed herein includes identifying presence of a low-voltage period in the plurality of battery units, based on the OCV deviation of the plurality of battery units, in which the setting of the threshold deviation includes setting the threshold deviation based on the presence of the low-voltage period.

In the battery diagnosis method according to an embodiment disclosed herein, the setting of the threshold deviation may include setting the threshold deviation to a third threshold deviation when it is identified that the low-voltage period is present and setting the threshold deviation to a fourth threshold deviation that is greater than the third threshold deviation when it is identified that the low-voltage period is not present.

In the battery diagnosis method according to an embodiment disclosed herein, the diagnosing of abnormality of the higher-level battery unit may include comparing a maximum value among the plurality of OCV deviation change values of the plurality of battery units with the threshold deviation to diagnose abnormality of the higher-level battery unit.

### [ADVANTAGEOUS EFFECTS]

According to embodiments disclosed herein, data used for abnormality diagnosis of a battery may be simplified.

According to embodiments disclosed herein, by setting a threshold deviation used in diagnosis, based on a time length of a time window calculated based on an OCV deviation change value and/or presence of a low-voltage period in a battery, accuracy in battery abnormality diagnosis may be improved.

Moreover, various effects recognized directly or indirectly from the disclosure may be provided.

### [DESCRIPTION OF DRAWINGS]

FIG. 1 is a block diagram of a battery diagnosis apparatus according to an embodiment.
FIG. 2 is a view for describing an example in which a battery diagnosis apparatus calculates a determination value.
FIG. 3 is a view for describing an example in which a battery diagnosis apparatus calculates an OCV deviation change value among determination values.
FIG. 4 is a view for describing an example in which a battery diagnosis apparatus calculates an OCV deviation change value among determination values.
FIG. 5 is an operating flowchart of a battery diagnosis apparatus according to an embodiment.
FIG. 6 is an operating flowchart of a battery diagnosis apparatus according to an embodiment.
FIG. 7 is an operating flowchart of a battery diagnosis apparatus according to an embodiment.

### [MODE FOR INVENTION]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present document and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

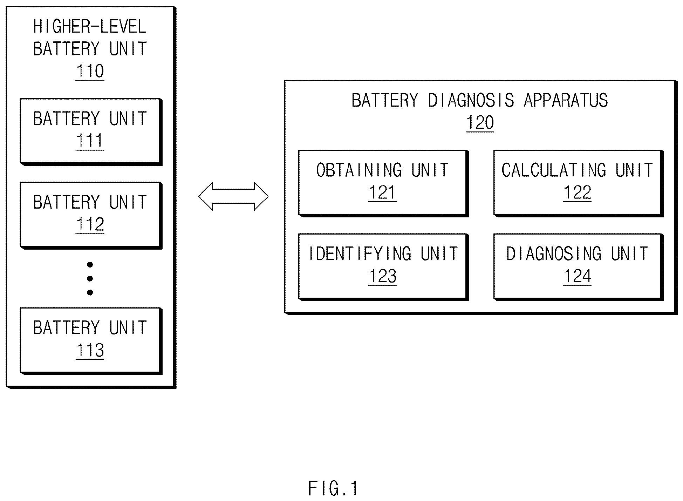

FIG. 1 is a block diagram of a battery diagnosis apparatus according to an embodiment.

Referring to FIG. 1, a higher-level battery unit 110 may include a plurality of battery units 111, 112, and 113. According to an embodiment, the higher-level battery unit 110 may be a battery pack mounted inside an electric vehicle to supply power to the electric vehicle or a battery module included in the battery pack. When the higher-level battery unit 110 is a battery pack, the plurality of battery units 111, 112, and 113 may be a plurality of battery modules or a plurality of battery cells. When the higher-level battery unit 110 is a battery module, the plurality of battery units 111, 112, and 113 may be a plurality of battery cells.

According to an embodiment, a battery diagnosis apparatus 120 may diagnose abnormality of the higher-level battery unit 110, based on OCV data obtained from the higher-level battery unit 110 and/or the battery unit 111, 112, and/or 113.

According to an embodiment, the battery diagnosis apparatus 120 may be formed integrally with the higher-level battery unit 110. In this case, the battery diagnosis apparatus 120 may be included in a battery management system (BMS) of the higher-level battery unit 120.

According to an embodiment, the battery diagnosis apparatus 120 may be formed separately from the higher-level battery unit 110. In this case, the battery diagnosis apparatus 120 may be implemented with an external server connected to the higher-level battery unit 110 and/or the battery unit 111, 112, and/or 113 over a wireless network.

According to an embodiment, the battery diagnosis apparatus 120 may include an obtaining unit 121, a calculating unit 123, an identifying unit 123, and/or a diagnosing unit 124. Depending on an embodiment, the identifying unit 123 may not be included in the battery diagnosis apparatus 120.

According to an embodiment, the obtaining unit 121 may obtain OCV data of the battery unit 111, 112, and/or 113. For example, the obtaining unit 121 may measure voltages, currents, and/or temperatures of the battery unit 111, 112, and/or 113 and configure OCV data based on the measured information. In this case, the obtaining unit 121 may include a sensor for measuring the voltages, currents, and/or temperatures and a processor for configuring OCV data based on the measured information. In another example, the obtaining unit 121 may receive OCV data of the battery unit 111, 112, and/or 113, obtained by the higher-level battery unit 110 or the battery unit 111, 112, and/or 113. In this case, the obtaining unit 121 may include a communication circuit capable of performing wired and/or wireless network communication.

According to an embodiment, the calculating unit 122 may calculate a determination value (e.g., an OCV deviation and/or OCV deviation change value) based on the OCV data obtained by the obtaining unit 121. According to an embodiment, the calculating unit 122 may extract OCV data in a designated voltage range (e.g., a voltage range of 3.9 V or greater) from the OCV data. The calculating unit 122 may calculate the determination value based on the extracted OCV data in the designated voltage range.

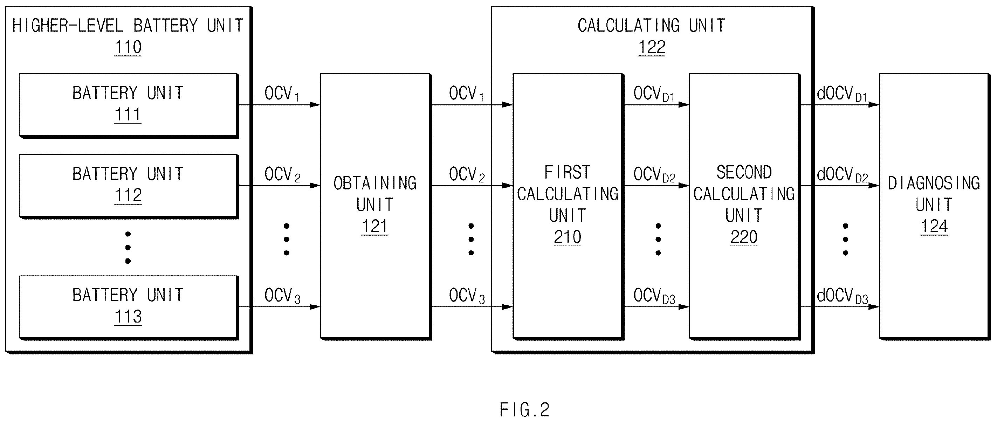

Hereinbelow, various embodiments where the calculating unit 122 calculates a determination value will be described with reference to FIGS. 2 to 4.

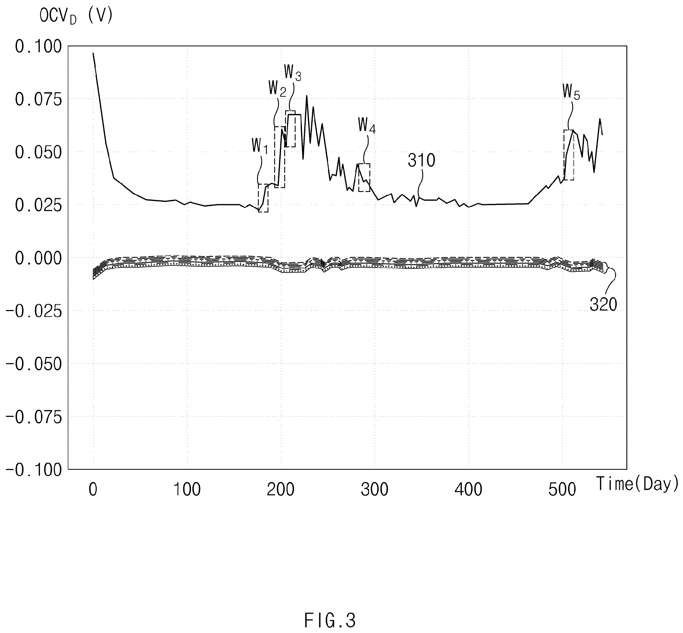

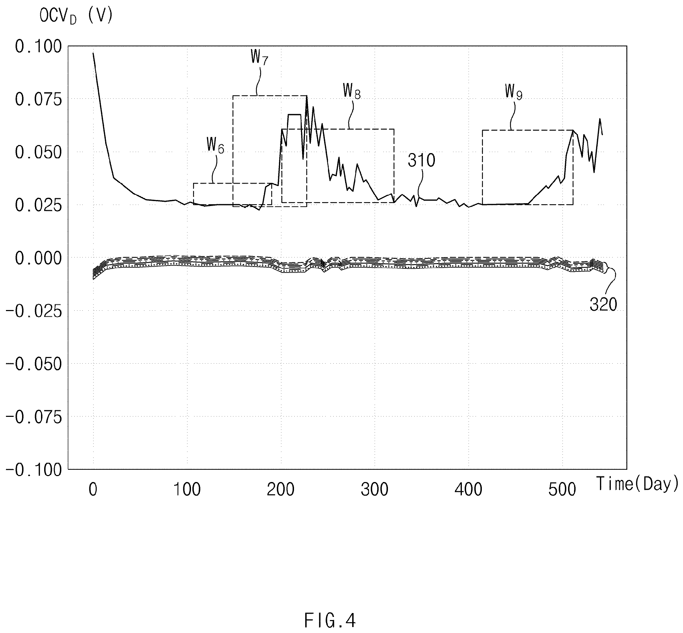

FIG. 2 is a view for describing an example in which a battery diagnosis apparatus calculates a determination value. FIG. 3 is a view for describing an example in which a battery diagnosis apparatus calculates an OCV deviation change value. FIG. 4 is a view for describing an example in which a battery diagnosis apparatus calculates an OCV deviation change value.

Referring to FIG. 2, the calculating unit 122 may include a first calculating unit 210 and a second calculating unit 220.

According to an embodiment, the obtaining unit 121 may transmit OCV data OCV₁, OCV₂, and OCV₃ of the plurality of battery units 111, 112, and 113 to the first calculating unit 210.

According to an embodiment, the first calculating unit 210 may calculate OCV deviations OCV_{D1}, OCV_{D2}, and OCV_{D3} indicating difference values between an average OCV of the plurality of battery units 111, 112, and 113 included in the higher-level battery unit 110 and OCVs of the plurality of battery units 111, 112, and 113, based on the OCV data OCV₁, OCV₂, and OCV₃. For example, the first calculating unit 210 may calculate OCV deviations 310 and 320 of the plurality of battery units 111, 112, and 113, as in graphs of FIGS. 3 and 4.

According to an embodiment, the first calculating unit 210 may transmit the calculated OCV deviations OCV_{D1}, OCV_{D2}, and OCV_{D3} to the second calculating unit 210.

According to an embodiment, the second calculating unit 220 may calculate a plurality of OCV deviation values dOCV_{D1}, dOCV_{D2}, and dOCV_{D3} in at least one time window of the plurality of battery units 111, 112, and 113. Herein, each of the OCV deviation values dOCV_{D1}, dOCV_{D2}, and dOCV_{D3} may correspond to each of the plurality of battery units 111, 112, and 113. Each of the OCV deviation values dOCV_{D1}, dOCV_{D2}, and dOCV_{D3} may include at least one OCV deviation value of each of the plurality of battery units 111, 112, and 113, in at least one time window. For example, the first OCV deviation value dOCV_{D1} may include at least one OCV deviation value in at least one time window of the battery unit 111.

According to an embodiment, the calculating unit 122 may limit a time length of at least one time window to a designated range. For example, the calculating unit 122 may limit at least one time window to a first time length or less. In another example, the calculating unit 122 may limit at least one time window to at least a second time length but not more than a third time length that is greater than the second time length. Herein, the second time length may be greater than the first time length. However, this is merely an example and the designated range may be set variously.

According to an embodiment, the second calculating unit 220 may calculate a plurality of OCV deviation change values in at least one time windows W₁, W₂, W₃, W₄, and W₅ limited to the first time length (e.g., 10 days) or less as shown in FIG. 3. For example, the second calculating unit 220 may calculate at least one OCV deviation change values in the at least one time windows W₁, W₂, W₃, W₄, and W₅ based on OCV deviation 310 data of the battery unit 111. In the same manner, the second calculating unit 220 may calculate at least one OCV deviation change values in the at least one time windows W₁, W₂, W₃, W₄, and W₅ based on OCV deviation 320 data of the other battery units 112 and 113. While it is shown in FIG. 3 that five time windows W₁, W₂, W₃, W₄, and W₅ are shown, this is merely an example and the number of time windows and the range of time windows are not limited.

According to an embodiment, the second calculating unit 220 may calculate a plurality of OCV deviation change values in at least one time windows W₆, W₇, W₈, and W₉ limited to at least the second time length (e.g., 80 days) but not more than the third time length (e.g., 120 days) that is greater than the second time length, as shown in FIG. 4. For example, the second calculating unit 220 may calculate at least one deviation change values in the at least one time windows W₆, W₇, W₈, and W₉ based on OCV deviation 310 data of the battery unit 111. In the same manner, the second calculating unit 220 may calculate at least one OCV deviation change values in the at least one time windows W₆, W₇, W₈, and W₉ based on OCV deviation 320 data of the other battery units 112 and 113. While it is shown in FIG. 4 that four time windows W₆, W₇, W₈, and W₉ are shown, this is merely an example and the number of time windows and the range of time windows are not limited.

According to an embodiment, the second calculating unit 220 may transmit the plurality of calculated OCV deviation values dOCV_{D1}, dOCV_{D2}, and dOCV_{D3} to the diagnosing unit 124.

Referring back to FIG. 1, the identifying unit 123 may identify presence of a low-voltage period in the plurality of battery units 111, 112, and 113, based on the OCV deviations of the plurality of battery units 111, 112, and 113, calculated by the calculating unit 122. For example, the identifying unit 123 may identify that the low-voltage period is present when there is a battery unit having an OCV deviation of a designated value (e.g., 0.015 mV) or greater among the plurality of battery units 111, 112, and 113.

According to an embodiment, the diagnosing unit 124 may set a threshold deviation corresponding to the higher-level battery unit 110. More specifically, the diagnosing unit 124 may set a threshold deviation to be used in abnormality diagnosis of the higher-level battery unit 110.

According to an embodiment, the diagnosing unit 124 may set the threshold deviation based on the designated range limited by the calculating unit 122. For example, the diagnosing unit 124 may set the threshold deviation to a first threshold deviation when the designated range is less than or equal to the first time length. The diagnosing unit 124 may set the threshold deviation to a second threshold deviation that is greater than the first threshold deviation, when the designated range is at least the second time length but not more than the third time length that is greater than the second time length. As such, the battery diagnosis apparatus 120 may differently set a threshold deviation to be used in diagnosis (more specifically, set a greater threshold deviation for a greater time length of a time window) based on an OCV deviation change value calculated based on a shorter time window and an OCV deviation change value calculated based on a longer time window, thereby improving the accuracy of the diagnosis.

According to an embodiment, the diagnosing unit 124 may set the threshold deviation based on the presence of the low-voltage period in the plurality of battery units 111, 112, and 113 identified by the identifying unit 123. For example, the diagnosing unit 124 may set the threshold deviation to a third threshold deviation when it is identified that the low-voltage period is present. The diagnosing unit 124 may set the threshold deviation to a fourth threshold deviation that is greater than the third threshold deviation when it is identified that the low-voltage period is not present. This is because when there is a low-voltage battery unit among the plurality of battery units 111, 112, and 113, the higher-level battery unit 110 may perform voltage balancing of the plurality of battery units 111, 112, and 113, thus increasing an OCV deviation. That is, the battery diagnosis apparatus 120 may prevent misdiagnosis from occurring due to voltage balancing by setting the threshold deviation to be a greater value, when the low-voltage period is present.

According to an embodiment, the diagnosing unit 124 may set the threshold deviation based on the designated range and presence of the low-voltage period. That is, the diagnosing unit 124 may set the threshold deviation based on both the designated range and presence of the low-voltage period.

According to an embodiment, the diagnosing unit 124 may set the threshold deviation to a fifth threshold deviation or a sixth threshold deviation when the designated range is less than or equal to the first time length. The sixth threshold deviation may be greater than the fifth threshold deviation. For example, the diagnosing unit 124 may set the threshold deviation to the fifth threshold deviation in the case of presence of the low-voltage period, and set the threshold deviation to the sixth threshold deviation in the case of absence of the low-voltage period.

According to an embodiment, the diagnosing unit 124 may set the threshold deviation to a seventh threshold deviation or an eighth threshold deviation when the designated range is the second time length or greater and is the third time length or less. Herein, the seventh threshold deviation and the eighth threshold deviation may be greater than the fifth threshold deviation and the sixth threshold deviation. The eighth threshold deviation may be greater than the seventh threshold deviation. For example, the diagnosing unit 124 may set the threshold deviation to the seventh threshold deviation in the case of presence of the low-voltage period, and set the threshold deviation to the eighth threshold deviation in the case of absence of the low-voltage period.

According to an embodiment, the diagnosing unit 124 may diagnose abnormality of the higher-level battery unit 110 based on the plurality of OCV deviation change values of the plurality of battery units 111, 112, and 113 calculated by the calculating unit 122 and the set threshold deviation. According to an embodiment, the diagnosing unit 124 may compare a maximum value among the plurality of OCV deviation change values with the threshold deviation to diagnose abnormality of the higher-level battery unit 110. For example, the diagnosing unit 124 may diagnose the higher-level battery unit 110 as being abnormal when the maximum value among the plurality of OCV deviation change values is greater than or equal to the threshold deviation.

The calculating unit 122, the identifying unit 123, and the diagnosing unit 124 may be implemented as a single processor or separate processors. Herein, the processor may execute software to control at least one other component (e.g., a hardware or software component) of the battery diagnosis apparatus 120 connected to the processor and may process or compute various data.

According to an embodiment, the battery diagnosis apparatus 120 may transmit a battery diagnosis result to an external source (e.g., a cloud server or a user terminal). Herein, the cloud server may provide a service for providing a battery diagnosis result to each of a plurality of users. Moreover, the user terminal may include a terminal such as a personal computer (PC), a smartphone, etc.

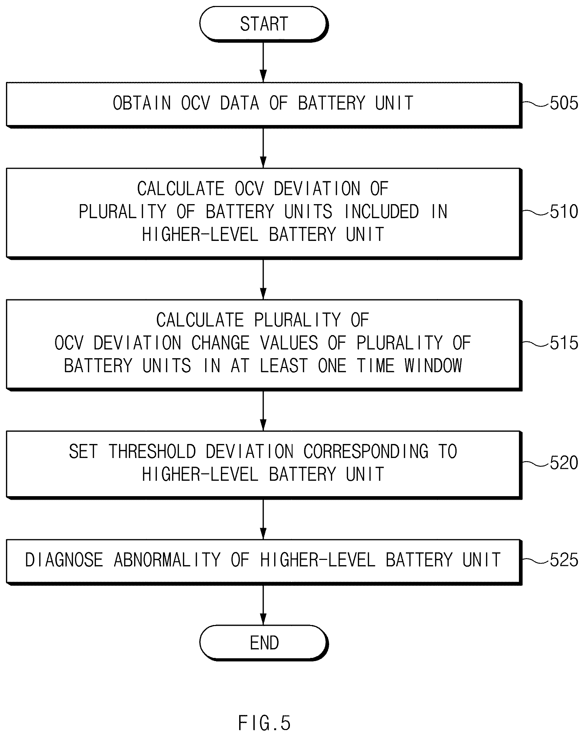

FIG. 5 is an operating flowchart of a battery diagnosis apparatus according to an embodiment. A description will be made of an operation of the battery diagnosis apparatus 120 of FIG. 1 with reference to FIG. 5 that may be described using FIG. 1.

The embodiment shown in FIG. 5 may be an example, and an order of operations according to various embodiments of the present disclosure may be different from that shown in FIG. 5, and some operations shown in FIG. 5 may be omitted, the order of the operations may be changed, or the operations may be merged.

Referring to FIG. 5, in operation 505, the battery diagnosis apparatus 120 may obtain OCV data of the battery unit 111, 112, and/or 113. For example, the battery diagnosis apparatus 120 may measure voltages, currents, and/or temperatures of the battery unit 111, 112, and/or 113 and configure the OCV data based on the measured information. In another example, the battery diagnosis apparatus 120 may receive the OCV data of the battery unit 111, 112, and/or 113, obtained by the higher-level battery unit 110 or the battery unit 111, 112, and/or 113.

In operation 510, the battery diagnosis apparatus 120 may calculate OCV deviations indicating differences between an average OCV of the plurality of battery units 111, 112, and 113 included in the higher-level battery unit 110 and OCVs of the plurality of battery units 111, 112, and 113, based on the OCV data obtained in operation 505. According to an embodiment, the battery diagnosis apparatus 120 may extract OCV data in a designated voltage range (e.g., a voltage range of 3.9 V or greater) from the OCV data. The battery diagnosis apparatus 120 may calculate the OCV deviation, based on the extracted OCV data in the designated voltage range.

In operation 515, the battery diagnosis apparatus 120 may calculate a plurality of OCV deviation values of the plurality of battery units 111, 112, and 113, in at least one time window. Herein, each of the OCV deviation values may correspond to each of the plurality of battery units 111, 112, and 113. Each of the OCV deviation values may include at least one OCV deviation value of each of the plurality of battery units 111, 112, and 113, in at least one time window.

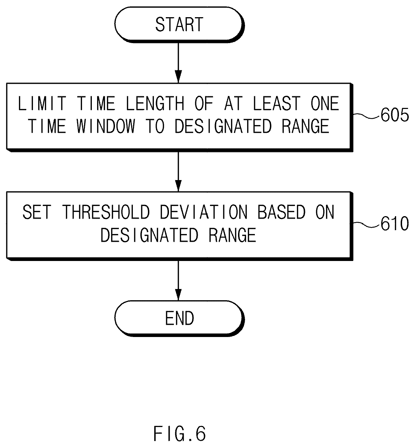

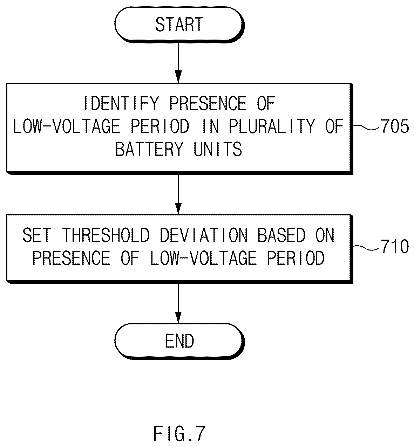

In operation 520, the battery diagnosis apparatus 120 may set a threshold deviation corresponding to the higher-level battery unit 110. More specifically, the battery diagnosis apparatus 120 may set a threshold deviation to be used in abnormality diagnosis of the higher-level battery unit 110. An operation, performed by the battery diagnosis apparatus 120, of setting the threshold deviation will be described in detail with reference to FIGS. 6 and 7.

In operation 525, the battery diagnosis apparatus 120 may diagnose abnormality of the higher-level battery unit 110. According to an embodiment, the battery diagnosis apparatus 120 may diagnose abnormality of the higher-level battery unit 110 based on the plurality of OCV deviation change values of the plurality of battery units 111, 112, and 113 calculated in operation 515 and the threshold deviation set in operation 520. According to an embodiment, the battery diagnosis apparatus 120 may compare a maximum value among the plurality of OCV deviation change values with the threshold deviation to diagnose abnormality of the higher-level battery unit 110. For example, the battery diagnosis apparatus 120 may diagnose the higher-level battery unit 110 as being abnormal when the maximum value among the plurality of OCV deviation change values is greater than or equal to the threshold deviation.

FIG. 6 is an operating flowchart of a battery diagnosis apparatus according to an embodiment. A description will be made of an operation of the battery diagnosis apparatus 120 of FIG. 1 with reference to FIG. 6 that may be described using the components of FIG. 1.

The embodiment shown in FIG. 6 may be an example, and an order of operations according to various embodiments of the present disclosure may be different from that shown in FIG. 6, and some operations shown in FIG. 6 may be omitted, the order of the operations may be changed, or the operations may be merged.

Referring to FIG. 6, in operation 605, the battery diagnosis apparatus 120 may limit a time length of the at least one time window described in operation 520 of FIG. 5 to a designated range. For example, the battery diagnosis apparatus 120 may limit at least one time window to the first time length or less. In another example, the battery diagnosis apparatus 120 may limit the at least one time window to at least the second time length but not more than the third time length that is greater than the second time length. Herein, the second time length may be greater than the first time length. However, this is merely an example and the designated range may be set variously.

In operation 610, the battery diagnosis apparatus 120 may set the threshold deviation based on the designated range limited in operation 605. For example, the battery diagnosis apparatus 120 may set the threshold deviation to a first threshold deviation when the designated range is less than or equal to the first time length. The battery diagnosis apparatus 120 may set the threshold deviation to a second threshold deviation that is greater than the first threshold deviation, when the designated range is at least the second time length but not more than the third time length that is greater than the second time length. As such, the battery diagnosis apparatus 120 may differently set a threshold deviation to be used in diagnosis based on an OCV deviation change value calculated based on a shorter time window and an OCV deviation change value calculated based on a longer time window, thereby improving the accuracy of the diagnosis.

FIG. 7 is an operating flowchart of a battery diagnosis apparatus according to an embodiment. A description will be made of an operation of the battery diagnosis apparatus 120 of FIG. 1 with reference to FIG. 7 that may be described using the components of FIG. 1.

The embodiment shown in FIG. 7 may be an example, and an order of operations according to various embodiments of the present disclosure may be different from that shown in FIG. 7, and some operations shown in FIG. 7 may be omitted, the order of the operations may be changed, or the operations may be merged.

Referring to FIG. 7, in operation 705, the battery diagnosis apparatus 120 may identify presence of a low-voltage period in the plurality of battery units 111, 112, and 113. According to an embodiment, the battery diagnosis apparatus 120 may identify presence of a low-voltage period in the plurality of battery units 111, 112, and 113, based on the OCV deviations of the plurality of battery units 111, 112, and 113, calculated in operation 510 of FIG. 5. For example, the battery diagnosis apparatus 120 may identify that the low-voltage period is present when there is a battery unit having an OCV deviation of a designated value (e.g., 0.015 mV) or greater among the plurality of battery units 111, 112, and 113.

In operation 710, the battery diagnosis apparatus 120 may set the threshold deviation based on the presence of the low-voltage period in the plurality of battery units 111, 112, and 113 identified in operation 705. For example, the battery diagnosis apparatus 120 may set the threshold deviation to a third threshold deviation when it is identified that the low-voltage period is present. The battery diagnosis apparatus 120 may set the threshold deviation to a fourth threshold deviation that is greater than the third threshold deviation when it is identified that the low-voltage period is not present. This is because when there is a low-voltage battery unit among the plurality of battery units 111, 112, and 113, the higher-level battery unit 110 may perform voltage balancing of the plurality of battery units 111, 112, and 113, thus increasing an OCV deviation. That is, the battery diagnosis apparatus 120 may prevent misdiagnosis from occurring due to voltage balancing by setting the threshold deviation to be a greater value, when the low-voltage period is present.

According to an embodiment, the battery diagnosis apparatus 120 may set the threshold deviation based on the designated range and presence of the low-voltage period. That is, the battery diagnosis apparatus 120 may set the threshold deviation based on both the designated range and presence of the low-voltage period.

According to an embodiment, the battery diagnosis apparatus 120 may set the threshold deviation to a fifth threshold deviation or a sixth threshold deviation when the designated range is less than or equal to the first time length. The sixth threshold deviation may be greater than the fifth threshold deviation. For example, the battery diagnosis apparatus 120 may set the threshold deviation to the fifth threshold deviation in the case of presence of the low-voltage period, and set the threshold deviation to the sixth threshold deviation in the case of absence of the low-voltage period.

According to an embodiment, the battery diagnosis apparatus 120 may set the threshold deviation to a seventh threshold deviation or an eighth threshold deviation when the designated range is the second time length or greater and is the third time length or less. Herein, the seventh threshold deviation and the eighth threshold deviation may be greater than the fifth threshold deviation and the sixth threshold deviation. The eighth threshold deviation may be greater than the seventh threshold deviation. For example, the battery diagnosis apparatus 120 may set the threshold deviation to the seventh threshold deviation in the case of presence of the low-voltage period, and set the threshold deviation to the eighth threshold deviation in the case of absence of the low-voltage period.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

## Claims

1. A battery diagnosis apparatus comprising:
an obtaining unit configured to obtain open circuit voltage (OCV) data of a battery unit;
a calculating unit configured to calculate an OCV deviation indicating a difference between an average OCV of a plurality of battery units included in a higher-level battery unit and OCVs of the plurality of battery units, based on the OCV data, and calculate a plurality of OCV deviation change values of the plurality of battery units in at least one time window; and
a diagnosing unit configured to set a threshold deviation corresponding to the higher-level battery unit and diagnose abnormality of the higher-level battery unit based on the plurality of OCV deviation change values of the plurality of battery units and the threshold deviation.

2. The battery diagnosis apparatus of claim 1, wherein the calculating unit is further configured to limit a time length of the at least one time window to a designated range, and
the diagnosing unit is further configured to set the threshold deviation based on the designated range.

3. The battery diagnosis apparatus of claim 2, wherein the diagnosing unit is further configured to:
set the threshold deviation to a first threshold deviation when the designated range is less than or equal to a first time length; and
set the threshold deviation to a second threshold deviation that is greater than the first threshold deviation, when the designated range is at least a second time length that is greater than the first time length but not more than a third time length that is greater than the second time length.

4. The battery diagnosis apparatus of claim 1, further comprising an identifying unit configured to identify presence of a low-voltage period in the plurality of battery units, based on the OCV deviation of the plurality of battery units,
wherein the diagnosing unit is further configured to set the threshold deviation based on the presence of the low-voltage period.

5. The battery diagnosis apparatus of claim 4, wherein the identifying unit is further configured to identify that the low-voltage period is present, when there is a battery unit having an OCV deviation greater than or equal to a designated value among the plurality of battery units.

6. The battery diagnosis apparatus of claim 4, wherein the diagnosing unit is further configured to:
set the threshold deviation to a third threshold deviation when it is identified that the low-voltage period is present; and
set the threshold deviation to a fourth threshold deviation that is greater than the third threshold deviation when it is identified that the low-voltage period is not present.

7. The battery diagnosis apparatus of claim 1, wherein the diagnosing unit is further configured to compare a maximum value among the plurality of OCV deviation change values of the plurality of battery units with the threshold deviation to diagnose abnormality of the higher-level battery unit.

8. The battery diagnosis apparatus of claim 7, wherein the diagnosing unit is further configured to diagnose that the higher-level battery unit is abnormal when the maximum value is greater than or equal to the threshold deviation.

9. The battery diagnosis apparatus of claim 1, wherein the calculating unit is further configured to:
extract OCV data in a designated voltage range from the OCV data; and
calculate the OCV deviation of the plurality of battery units, based on the extracted OCV data in the designated voltage range.

10. A battery diagnosis method comprising:
obtaining open circuit voltage (OCV) data of a battery unit;
calculating an OCV deviation indicating a difference between an average OCV of a plurality of battery units included in a higher-level battery unit and OCVs of the plurality of battery units, based on the OCV data;
calculating a plurality of OCV deviation change values of the plurality of battery units in at least one time window;
setting a threshold deviation corresponding to the higher-level battery unit; and
diagnosing abnormality of the higher-level battery unit based on the plurality of OCV deviation change values of the plurality of battery units and the threshold deviation.

11. The battery diagnosis method of claim 10, further comprising limiting a time length of the at least one time window to a designated range,
wherein the setting of the threshold deviation comprises setting the threshold deviation based on the designated range.

12. The battery diagnosis method of claim 11, wherein the setting of the threshold deviation comprises:
setting the threshold deviation to a first threshold deviation when the designated range is less than or equal to a first time length; and
setting the threshold deviation to a second threshold deviation that is greater than the first threshold deviation, when the designated range is at least a second time length that is greater than the first time length but not more than a third time length that is greater than the second time length.

13. The battery diagnosis method of claim 10, further comprising identifying presence of a low-voltage period in the plurality of battery units, based on the OCV deviation of the plurality of battery units,
wherein the setting of the threshold deviation comprises setting the threshold deviation based on the presence of the low-voltage period.

14. The battery diagnosis method of claim 13, wherein the setting of the threshold deviation comprises:
setting the threshold deviation to a third threshold deviation when it is identified that the low-voltage period is present; and
setting the threshold deviation to a fourth threshold deviation that is greater than the third threshold deviation when it is identified that the low-voltage period is not present.

15. The battery diagnosis method of claim 10, wherein the diagnosing of abnormality of the higher-level battery unit comprises comparing a maximum value among the plurality of OCV deviation change values of the plurality of battery units with the threshold deviation to diagnose abnormality of the higher-level battery unit.
